# EUROPEAN PATENT APPLICATION

(11) **EP 4 694 589 A1**
(43) Date of publication of application: **11.02.2026**
(21) Application number: 24777790.7
(22) Date of filing: 19.03.2024
(51) Int. Cl.: H05K 3/42, H05K 1/11

(54) **PREPARATION METHOD FOR PRINTED CIRCUIT BOARD, PRINTED CIRCUIT BOARD AND ELECTRONIC DEVICE**

(30) Priority: 28.03.2023 CN 202310352344
(71) Applicant: ZTE CORPORATION, Shenzhen, Guangdong 518057 (CN)
(72) Inventor: XIE, Jian, Shenzhen, Guangdong 518057 (CN); WEI, Zhongmin, Shenzhen, Guangdong 518057 (CN); YIN, Changgang, Shenzhen, Guangdong 518057 (CN)
(74) Representative: Canzler & Bergmeier Patentanwälte Partnerschaft mbB
(86) International application number: PCT/CN2024/082378
(87) International publication number: WO 2024/199001

(57) **Abstract**

Provided in the present disclosure is a preparation method for a printed circuit board, the preparation method comprising: forming a layer structure body comprising a plated-through hole, wherein the plated-through hole penetrates through the layer structure body; forming a first back-drilling hole at the position, corresponding to the plated-through hole, of one side of a first surface of the layer structure body, wherein the first back-drilling hole extends to a first dielectric layer of the layer structure body, and the plated-through hole forms a back-drilling stub in the first dielectric layer; and forming a second back-drilling hole in the first dielectric layer by means of etching so as to remove the back-drilling stub, wherein one end of the second back-drilling hole is connected to the first back-drilling hole, and the other end of the second back-drilling hole is connected to the plated-through hole. Further provided in the present disclosure are a printed circuit board and an electronic device.

## Description

### CROSS-REFERENCE TO RELATED APPLICATIONS

This application claims priority from Chinese patent application No. 202310352344.8 filed on March 28, 2023, the entirety of which is incorporated hereby by reference.

### TECHNICAL FIELD

The present disclosure relates to the technical field of printed circuits, and specifically relates to a method for preparing a printed circuit board, a printed circuit board, and an electronic device.

### BACKGROUND

The printed circuit board (PCB) product with a rate up to 112Gbps has already begun to be commercialized, and the rate is still increasing. The existing PCB designs will fail if a higher rate of 224Gbps is to be reached.

A prominent bottleneck limiting the development of PCBs at higher rates is the presence of back-drilled stubs, and therefore, how to reduce back-drilled stubs and improve the transmission quality of signals in the PCBs has become an urgent problem to be solved.

### SUMMARY

In an aspect, an embodiment of the present disclosure provides a method for preparing a printed circuit board, including: forming a layer structure body with a plated through hole penetrating through the layer structure body; forming a first back-drilled hole at a position, corresponding to the plated through hole, of a first surface of the layer structure body, the first back-drilled hole extending to a first dielectric layer of the layer structure body, and the plated through hole forming a back-drilled stub in the first dielectric layer; and forming a second back-drilled hole in the first dielectric layer by etching to remove the back-drilled stub, an end of the second back-drilled hole being connected to the first back-drilled hole, and another end of the second back-drilled hole being connected to the plated through hole.

In another aspect, an embodiment of the present disclosure provides a printed circuit board prepared by the method described above, the printed circuit board includes a layer structure body including a plated through hole, a first back-drilled hole, and a second back-drilled hole, the first back-drilled hole is proximal to a first surface of the layer structure body and corresponds to the plated through hole, the second back-drilled hole is located in a first dielectric layer of the layer structure body, and two ends of the second back-drilled hole are connected to the plated through hole and the first back-drilled hole, respectively.

In another aspect, an embodiment of the present disclosure further provides an electronic device, including the printed circuit board as described above.

### BRIEF DESCRIPTION OF DRAWINGS

FIG. 1 is a schematic diagram of a back-drilled stub in the existing art;
FIG. 2 is a schematic flowchart of a method for preparing a printed circuit board according to an embodiment of the present disclosure;
FIGs. 3a to 3i are schematic diagrams illustrating a process of preparing a printed circuit board according to an embodiment of the present disclosure;
FIG. 4 is a schematic comparison between insertion loss of the existing art and insertion loss according to an embodiment of the present disclosure; and
FIG. 5 is a schematic structural diagram of a printed circuit board according to an embodiment of the present disclosure.

### DETAIL DESCRIPTION OF EMBODIMENTS

Exemplary embodiments will be described more sufficiently below with reference to the accompanying drawings, but may be embodied in different forms and the present disclosure should not be construed as limited to the embodiments set forth herein. These embodiments are provided so that the present disclosure will be more thorough and complete, and will fully convey the scope of the present disclosure to those skilled in the art.

As used herein, the term "and/or" includes any and all combinations of one or more of the associated listed items.

The terminology used herein is for the purpose of describing specific embodiments only, instead of limiting the present disclosure. As used herein, the singular forms "a", "an" and "the" include the plural forms as well, unless the context clearly indicates otherwise. It will be further understood that as used herein, the terms "comprise" and/or "consist of ..." specify the presence of specific features, integers, steps, operations, elements, and/or components, but do not preclude the presence or addition of one or more other features, entities, steps, operations, elements, components, and/or groups thereof.

Embodiments described herein may be described with reference to plan and/or sectional views in idealized representations of the present disclosure. Accordingly, the example illustrations may be modified in accordance with the manufacturing process and/or the tolerance. Therefore, the embodiments are not limited to the embodiments shown in the drawings, but further include modifications of configurations formed based on a manufacturing process. Thus, the regions illustrated in the figures have schematic properties, and the shapes of the regions shown in the figures illustrate specific shapes of regions of elements, but are not intended to be limiting.

Unless otherwise defined, all terms (including technical and scientific terms) used herein have the same meaning as commonly understood by one of ordinary skill in the art. It will be further understood that terms, such as those defined in commonly used dictionaries, should be interpreted as having a meaning that is consistent with their meaning in the context of the existing art and the present disclosure, and will not be interpreted in an idealized or overly formal sense unless expressly so defined herein.

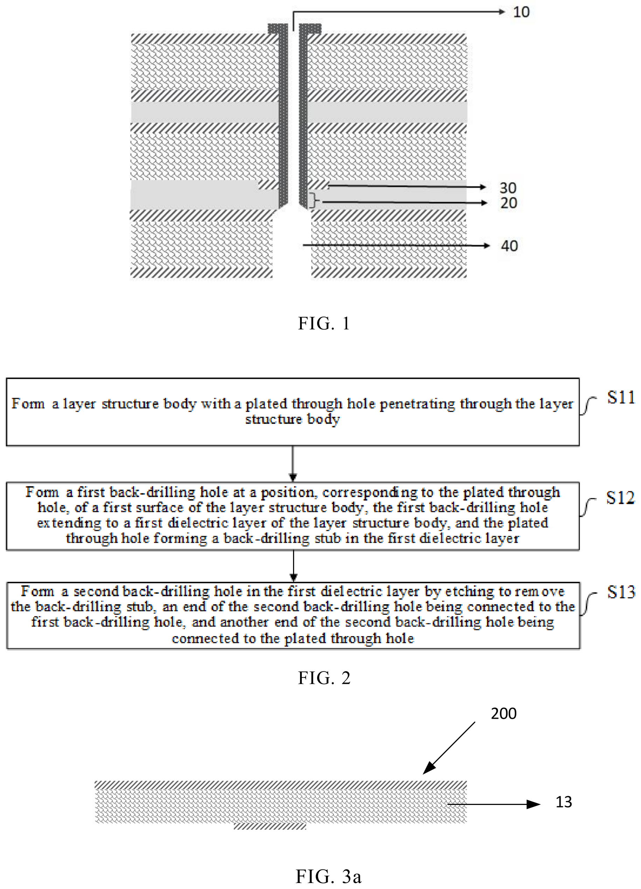

In the existing art, as shown in FIG. 1, a back-drilled stub 20 is generally left in a plated through hole 10 during the process of preparing a PCB, which may increase the transmission loss of a signal transmission component 30, and notably influence the signal transmission quality. Current back-drilled holes 40 are typically formed by machining. Limited by the influences of the processing equipment, the drill bit, the production process and the like, especially in a case where the PCB is laminated non-uniformly, the back-drilled stub 20 is hard to be removed.

An embodiment of the present disclosure provides a method for preparing a printed circuit board, including forming a back-drilled hole through a physical means and a chemical means in combination, i.e., forming a back-drilled hole through a physical means, and forming a back-drilled hole through a chemical means, and using the back-drilled holes together to achieve the purpose of removing the back-drilled stub.

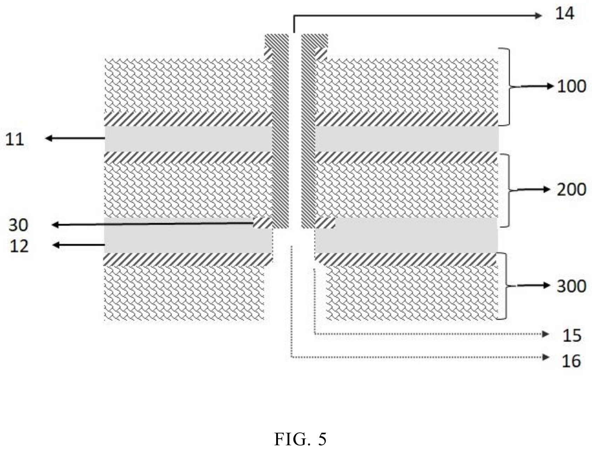

FIG. 2 is a schematic flowchart of a method for preparing a printed circuit board according to an embodiment of the present disclosure. FIG. 5 is a schematic structural diagram of a printed circuit board according to an embodiment of the present disclosure. FIGs. 3a to 3i are schematic diagrams illustrating a process of preparing a printed circuit board according to an embodiment of the present disclosure. As shown in FIGs. 2, 3a to 3i and 5, the method for preparing a printed circuit board includes following operations S11 to S13.

At operation S11, forming a layer structure body with a plated through hole penerating through the layer structure body.

The layer structure body forming the printed circuit board may have a single-layer structure (i.e., forming a single-layer printed circuit board) or a multi-layer structure (i.e., forming a multi-layer printed circuit board). In the printed circuit board having a multi-layer structure, two adjacent layer structures are connected via a first dielectric layer. In the embodiment of the present disclosure, a layer structure body including three layer-structures is taken as an example for illustration. That is, the layer structure body includes a first layer structure 100, a second layer structure 200, and a third layer structure 300. The second layer structure 200 is an intermediate layer structure of the layer structure body, and the first layer structure 100, the second layer structure 200, and the third layer structure 300 are copper core boards. The first layer structure 100 is connected to the second layer structure 200 via a first dielectric layer 11, and the second layer structure 200 is connected to the third layer structure 300 via a first dielectric layer 12.

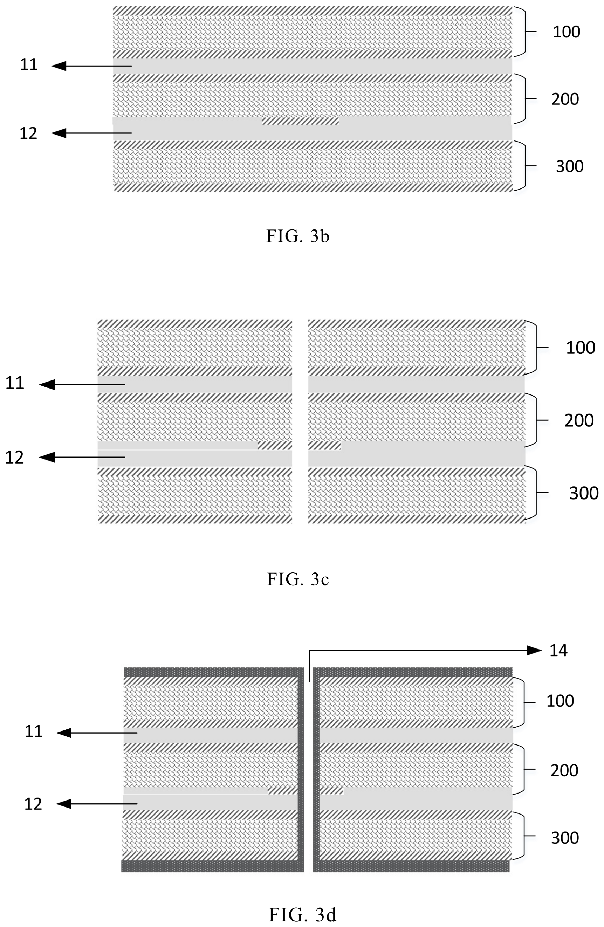

In this operation, as shown in FIG. 3a, a transmission line pattern is firstly formed on a copper core board. The copper core board includes two copper layers and a second dielectric layer 13. The two copper layers are located on two sides of the second dielectric layer 13, respectively, and the transmission line pattern is formed on one of the two copper layers to obtain the second layer structure 200. As shown in FIG. 3b, the first layer structure 100, the first dielectric layer 11, the second layer structure 200, the first dielectric layer 12, and the third layer structure 300 are stacked and laminated to obtain the layer structure body. The first dielectric layers 11, 12 may be prepregs, the first dielectric layers 11, 12 and the second dielectric layer 13 are typically composed of resin, glass fibers, fillers, or the like. As shown in FIG. 3c, the layer structure body in FIG. 3b is drilled to obtain a through hole penetrating through the layer structure body. As shown in FIG. 3d, for example, metal copper, is electroplated on an outer surface of the layer structure body and an inner wall of the through hole to form a plated through hole (i.e., metalized hole) 14 penetrating through the layer structure body.

The plated through hole 14 is located in a ball grid array (BGA) region and/or a connector region of the layer structure body. The plated through hole 14 is formed by rotating a drill bit in the layer structure body at a relatively high speed to form a hole structure, and then forming a metal on the hole structure through electroplating or chemical plating to obtain the plated through hole 14, the metal for the plated through hole 14 is generally copper.

At operation S12, forming a first back-drilled hole at a position, corresponding to the plated through hole, of a first surface of the layer structure body, the first back-drilled hole extending to a first dielectric layer of the layer structure body, and the plated through hole forming a back-drilled stub in the first dielectric layer.

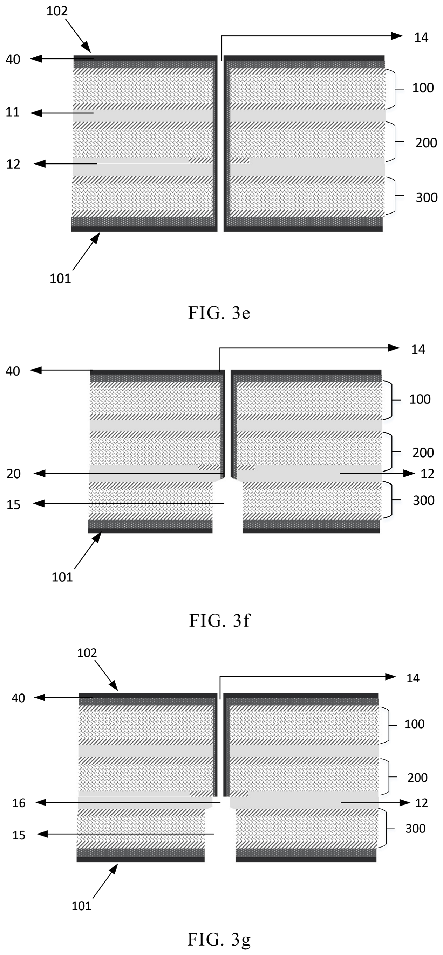

In the layer structure body shown in FIGs. 3a to 3i, a lower surface of the layer structure body is referred to as a first surface, and an upper surface of the layer structure body is referred to as a second surface. In this operation, as shown in FIG. 3f, a first back-drilled hole 15 is physically formed from the first surface 101 of the layer structure body, and extends to the first dielectric layer 12 proximal to the first surface 101, the plated through hole 14 forms a back-drilled stub 20 in the first dielectric layer 12. The first back-drilled hole 15 may be formed by machining.

At operation S13, forming a second back-drilled hole in the first dielectric layer by etching to remove the back-drilled stub, an end of the second back-drilled hole being connected to the first back-drilled hole, and another end of the second back-drilled hole being connected to the plated through hole.

As shown in FIGs. 3f and 3g, after the first back-drilled hole 15 is formed, a second back-drilled hole 16 is formed in the first dielectric layer 12 with the back-drilled stub 20 by chemical etching, and the back-drilled stub 20 can be removed during forming the second back-drilled hole 16.

As can be seen from the above operations S11 to S13, the method for preparing a printed circuit board provided in the embodiment of the present disclosure includes: forming a layer structure body with a plated through hole 14 penetrating through the layer structure body; forming a first back-drilled hole 15 at a position, corresponding to the plated through hole 14, of a first surface 101 of the layer structure body, the first back-drilled hole 15 extending to a first dielectric layer 12 of the layer structure body, and the plated through hole 14 forming a back-drilled stub 20 in the first dielectric layer 12; and forming a second back-drilled hole 16 in the first dielectric layer 12 by etching to remove the back-drilled stub 20, an end of the second back-drilled hole 16 being connected to the first back-drilled hole 15, and another end of the second back-drilled hole 16 being connected to the plated through hole 14. In the present disclosure, the second back-drilled hole 16 is further formed by etching, in addition to the first back-drilled hole 15, so that the back-drilled stub 20 can be removed, the signal transmission loss is reduced, and the signal transmission quality of PCB is improved.

Since the second back-drilled hole 16 is formed by etching in the embodiment of the present disclosure, to protect a region, not for forming the second back-drilled hole, of the layer structure body from being etched during the etching process, in some implementations, after forming the layer structure body with the plated through hole (i.e., operation S11), and before forming the second back-drilled hole in the first dielectric layer by etching to remove the back-drilled stub (i.e., operation S13), the method for preparing a printed circuit board may further include: applying a protection to the layer structure body to protect a region of the layer structure body not for forming the second back-drilled hole. It should be noted that the region of the layer structure body not for forming the second back-drilled hole refers to a region of the layer structure body other than the region for forming the second back-drilled hole.

Accordingly, after forming the second back-drilled hole in the first dielectric layer by etching to remove the back-drilled stub (i.e., operation S13), the method for forming a printed circuit board may further include: removing the protection from the layer structure body.

The embodiment of the present disclosure provides two modes of applying a protection to the layer structure body, which are described in detail below.

### First protection mode

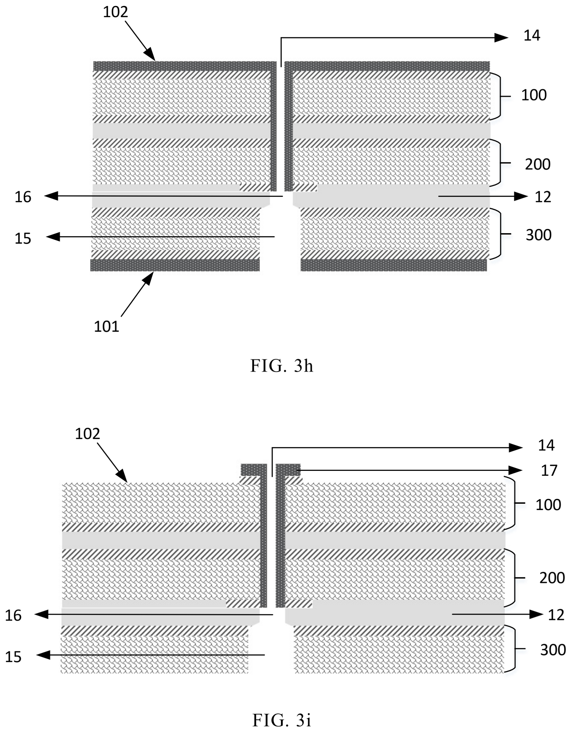

Applying a protection to the layer structure body to protect the region not for forming the second back-drilled hole includes: before forming the first back-drilled hole from the first surface of the layer structure body (i.e., operation S12), electroplating a metal not chemically reacting with an etchant on the first surface and a second surface of the layer structure body, and an inner wall of the plated through hole, the second surface being opposite to the first surface. Accordingly, removing the protection from the layer structure body includes: removing the metal electroplated on the first surface, the second surface, and the inner wall of the plated through hole. As shown in FIGs. 3e to 3h, before forming the first back-drilled hole 15 from the first surface 101 of the layer structure body, tin 40 is electroplated on the first surface 101 and the second surface 102 of the layer structure body, and an inner wall of the plated through hole 14 (as shown in FIG. 3e). Then, the first back-drilled hole 15 is formed from the first surface 101 of the layer structure body (as shown in FIG. 3f), and the second back-drilled hole 16 is formed in the first dielectric layer 12 proximal to the first surface 101 by etching to remove the back-drilled stub 20 (as shown in FIG. 3g). Then, the tin 40 electroplated on the first surface 101, the second surface 102 and the inner wall of the plated through hole 14 is removed (as shown in FIG. 3h).

In other words, in the first protection mode, metal electroplating is performed on the layer structure body in entire before the first back-drilled hole 15 is formed, then the first back-drilled hole 15 and the second back-drilled hole 16 are formed in sequence, and finally, the electroplated metal is removed. By electroplating a metal not chemically reacting with an etchant on the first surface 101 and the second surface 102 of the layer structure body, and an inner wall of the plated through hole 14, the metal copper on the first surface 101 and the second surface 102 and in the plated through hole 14 can be prevented from being etched away and thus affecting the signal transmission effect, in the process of forming the second back-drilled hole 16.

### Second protection mode

Applying a protection to the layer structure body to protect the region not for forming the second back-drilled hole includes: after forming the first back-drilled hole from the first surface of the layer structure body (i.e., operation S12), coating a dry film on the first surface and a second surface of the layer structure body, the second surface being opposite to the first surface. Accordingly, removing the protection from the layer structure body includes: removing the dry film coated on the first surface and the second surface.

In other words, in the second protection mode, the first back-drilled hole 15 is formed before coating a dry film on an entire outer layer of the layer structure body, then the second back-drilled hole 16 is formed, and finally, the dry film is removed. By coating the dry film on the first surface 101 and the second surface 102 of the layer structure body, the metal copper on the first surface 101 and the second surface 102 can be prevented from being etched away and thus affecting the signal transmission effect, in the process of forming the second back-drilled hole 16. It should be noted that the dry film coated does not chemically react with the etchant.

In some implementations, as shown in FIG. 3f, in a case where the layer structure body includes at least two layer-structures, the first back-drilled hole 15 extends to the first dielectric layer 12 of the layer structure body proximal to the first surface 101.

In some implementations, the first back-drilled hole 15 may have a depth of 2 mils to 7 mils.

In some implementations, the second back-drilled hole 16 may have a depth of 2 mils to 3 mils.

It should be noted that the depths of the first back-drilled hole 15 and the second back-drilled hole 16 may be adjusted according to the process level during the production process.

In some implementations, after forming the second back-drilled hole in the first dielectric layer by etching to remove the back-drilled stub (i.e., operation S13), the method for forming a printed circuit board further includes: forming a pad pattern on a second surface of the layer structure body. In this operation, as shown in FIG. 3i, the metal copper electroplated in the operation shown in FIG. 3d and the copper layer in the first layer structure 100 are patterned from the second surface 102 of the layer structure body, and a pad 17 is formed at a position corresponding to the plated through hole 14. The pad 17 is located on the second surface 102 of the layer structure body. The pad 17 is electrically connected to a signal input terminal or a signal output terminal of the printed circuit board. The pad 17 covers the plated through hole 14, and is connected to a wall of the plated through hole 14. The pad 17 is typically made of a material of copper. It should be noted that, in addition to forming the pad pattern on the second surface 102 of the layer structure body, the metal copper electroplated on the first surface 101 of the layer structure body is removed, thereby obtaining the printed circuit board structure shown in FIG. 3i.

After the printed circuit board structure shown in FIG. 3i is obtained, outer layer surfaces of the layer structure body, such as the first surface 101 and the second surface 102, may be further processed, for example, by planarization, milling or the like.

Signal transmission lines are deployed with a same width in a same plane, so that the impedance remains unchanged, which can ensure that signals are transmitted indiscriminately and the reflection is reduced, thereby ensuring the signal quality to the maximum extent. However, if any signal transmission line is used for a transmission penetrating through a layer, the impedance thereof will change, leading to an increased reflection and an increased signal loss, as well as reduced quality of the transmitted signal. In a case where a signal is transmitted through the plated through hole 14 which penetrates through a layer to connect transmission lines, if the signal is input to the first layer structure 100 of the printed circuit board which is three-layered, and output from the second layer structure 200 of the printed circuit board after passing through the plated through hole 14, the back-drilled stub 20 formed by the plated through hole 14 between the second layer structure 200 and the third layer structure 300 of the printed circuit board may cause signal loss. Therefore, in the implementations of the present disclosure, the back-drilled stub formed in the first dielectric layer 12 by the plated through hole 14 can be completely removed by means of the first back-drilled hole 15 and the second back-drilled hole 16, thereby reducing the signal loss and improving the signal tran smission quality.

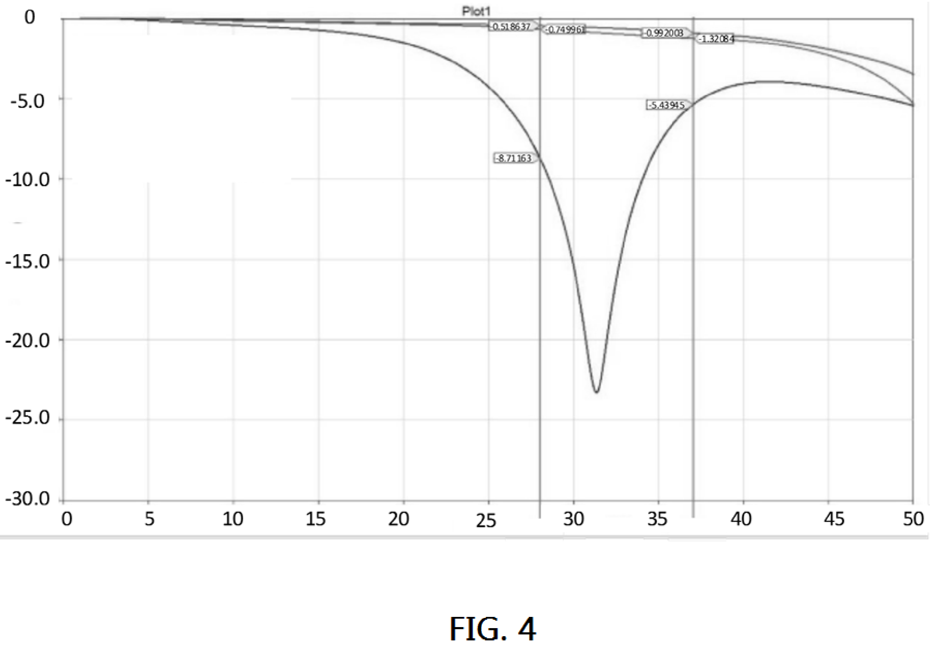

FIG. 4 is a schematic comparison between insertion loss of the existing art and insertion loss according to an embodiment of the present disclosure. The test experimental effects according to the embodiment of the present disclosure will be described below with reference to FIG. 4.

As shown in FIG. 4, the lowermost curve in the figure is a signal insertion loss curve of a PCB prepared by the method for preparing a printed circuit board provided in the embodiment of the present disclosure (i.e., a PCB including a first back-drilled hole and a second back-drilled hole); the uppermost curve in the figure is a signal insertion loss curve of a PCB without a back-drilled hole (i.e., a PCB without any back-drilled hole); and the middle curve in the figure is a signal insertion loss curve of the PCB shown in FIG. 1 (i.e., a PCB with only a first back-drilled hole). In FIG. 4, the abscissa represents frequency, and the ordinate represents insertion loss. As can be seen from the figure, at a higher frequency, the PCB in the embodiment of the present disclosure has lower signal insertion loss and better signal integrity.

Starting from the design of a PCB, the method for preparing a printed circuit board provided in the embodiment of the present disclosure realizes a multi-purpose process of removing a back-drilled stub and a fault through one hole, which solves the bottleneck problem in the existing process of manufacturing a PCB, and exhibits a design result based on a theory of Electronic Design Automation (EDA) to the maximum extent. In the embodiment of the present disclosure, the back-drilled stub is removed by etching, which can fundamentally solve the problem of a back-drilled stub being left, and reduce the back-drilled stub by 1 mil to 4 mils. Compared with the existing PCB with a back-drilled stub, the signal loss of the signal transmission line can be reduced by 25% to 30%, thereby improving the signal quality.

An embodiment of the present disclosure further provides a printed circuit board prepared by the method for preparing a printed circuit board as described above. As shown in FIG. 5, the printed circuit board includes a layer structure body including a plated through hole 14, a first back-drilled hole 15, and a second back-drilled hole 16. The first back-drilled hole 15 is proximal to a first surface 101 of the layer structure body and corresponds to the plated through hole 14. The second back-drilled hole 16 is located in a first dielectric layer 12 of the layer structure body (i.e., the first dielectric layer proximal to the first surface 101 of the layer structure body), and two ends of the second back-drilled hole 16 are connected to the plated through hole 14 and the first back-drilled hole 15, respectively. The second back-drilled hole 16 is configured to remove a back-drilled stub so that an end of the plated through hole 14 proximal to the first surface 101 has a smaller or even no back-drilled stub in the first dielectric layer 12.

In the embodiment of the present disclosure, a layer structure body including three layer-structures is taken as an example for illustration. As shown in FIG. 5, the layer structure body includes a first layer structure 100, a second layer structure 200, and a third layer structure 300, and the second back-drilled hole 16 is located in the first dielectric layer 12 between the second layer structure 200 and the third layer structure 300.

It should be noted that the second layer structure 200 further includes a signal transmission component 30, which is formed by patterning a copper layer of the second layer structure 200, and a surface of the signal transmission component 30 proximal to the first surface 101 is flush with a surface of the plated through hole 14 proximal to the first surface 101.

An embodiment of the present disclosure further provides an electronic device, including the printed circuit board as described above.

The embodiments of the present disclosure are suitable for high-speed printed circuit board products, especially wired and wireless products with a rate of 224Gbps or above, and may be applied to printed circuit boards with a designed rate of 224Gbps or above, or printed circuit boards with a designed rate lower than 224Gbps but having higher expectations on signal quality (i.e., expecting less signal loss).

Those of ordinary skill in the art will appreciate that all or some operations of the method described above, function modules/units in the apparatus may be implemented as software, firmware, hardware, and suitable combinations thereof. In a hardware implementation, the division between the function modules/units mentioned in the above description does not necessarily correspond to the division of physical components; for example, one physical component may have multiple functions, or one function or operation may be performed cooperatively by several physical components. Some or all physical components may be implemented as software executed by a processor, such as a CPU, a digital signal processor or microprocessor, or implemented as hardware, or implemented as an integrated circuit, such as an application specific integrated circuit. Such software may be distributed on a computer-readable medium which may include a computer storage medium (or non-transitory medium) and a communication medium (or transitory medium). The term computer storage medium includes volatile and nonvolatile, removable and non-removable media implemented in any method or technology for storage of information such as computer-readable instructions, data structures, program modules or other data, as is well known to those of ordinary skill in the art. The computer storage medium includes, but is not limited to, an RAM, an ROM, an EEPROM, a flash or any other memory technology, a CD-ROM, a digital versatile disk (DVD) or any other optical disk storage, a magnetic cartridge, a magnetic tape, a magnetic disk storage or any other magnetic storage device, or may be any other medium used for storing the desired information and accessible by a computer. Moreover, it is well known to those of ordinary skill in the art that a communication medium typically includes a computer-readable instruction, a data structure, a program module, or other data in a modulated data signal, such as a carrier wave or other transport mechanism, and may include any information delivery medium.

The present disclosure has disclosed exemplary embodiments, and although specific terms are employed, they are used and should be interpreted merely in a generic and descriptive sense, not for purposes of limitation. In some instances, features, characteristics and/or elements described in connection with a particular embodiment may be used alone, or may be used in combination with features, characteristics and/or elements described in connection with other embodiments, unless expressly stated otherwise, as would be apparent to one skilled in the art. It will, therefore, be understood by those skilled in the art that various changes in form and details may be made without departing from the scope of the present disclosure as set forth in the appended claims.

## Claims

1. A method for preparing printed circuit board, comprising:
forming a layer structure body with a plated through hole penetrating through the layer structure body;
forming a first back-drilled hole at a position, corresponding to the plated through hole, of a first surface of the layer structure body, wherein the first back-drilled hole extends to a first dielectric layer of the layer structure body, and the plated through hole forms a back-drilled stub in the first dielectric layer; and
forming a second back-drilled hole in the first dielectric layer by etching to remove the back-drilled stub, wherein an end of the second back-drilled hole is connected to the first back-drilled hole, and another end of the second back-drilled hole is connected to the plated through hole.

2. The method according to claim 1, further comprising: after forming the layer structure body with the plated through hole, and before forming the second back-drilled hole in the first dielectric layer by etching to remove the back-drilled stub, applying a protection to the layer structure body to protect a region not for forming the second back-drilled hole; and
after forming the second back-drilled hole in the first dielectric layer by etching to remove the back-drilled stub, removing the protection from the layer structure body.

3. The method according to claim 2, wherein applying the protection to the layer structure body to protect the region not for forming the second back-drilled hole comprises:
before forming the first back-drilled hole at the first surface of the layer structure body, electroplating a metal not chemically reacting with an etchant on the first surface and a second surface of the layer structure body, and an inner wall of the plated through hole, wherein the second surface is opposite to the first surface; and
removing the protection from the layer structure body comprises:
removing the metal electroplated on the first surface, the second surface, and the inner wall of the plated through hole.

4. The method according to claim 2, wherein applying the protection to the layer structure body to protect the region not for forming the second back-drilled hole comprises:
after forming the first back-drilled hole at the first surface of the layer structure body, coating a dry film on the first surface and a second surface of the layer structure body, wherein the second surface is opposite to the first surface; and
removing the protection from the layer structure body comprises:
removing the dry film coated on the first surface and the second surface.

5. The method according to claim 1, wherein the layer structure body comprises at least one layer structure, and adjacent layer structures are connected via the first dielectric layer; and
in response to the layer structure body comprising at least two layer-structures, the first back-drilled hole extends to the first dielectric layer of the layer structure body proximal to the first surface.

6. The method according to claim 1, wherein the first back-drilled hole has a depth of 2 mils to 7 mils.

7. The method according to claim 1, wherein the second back-drilled hole has a depth of 2 mils to 3 mils.

8. The method according to any one of claims 1 to 7, further comprising:
after forming the second back-drilled hole in the first dielectric layer by etching to remove the back-drilled stub, forming a pad pattern on a second surface of the layer structure body, wherein the second surface is opposite to the first surface.

9. A printed circuit board prepared by the method according to any one of claims 1 to 8, the printed circuit board comprises a layer structure body comprising a plated through hole, a first back-drilled hole, and a second back-drilled hole, the first back-drilled hole is proximal to a first surface of the layer structure body and corresponds to the plated through hole, the second back-drilled hole is located in a first dielectric layer of the layer structure body, and two ends of the second back-drilled hole are connected to the plated through hole and the first back-drilled hole, respectively.

10. An electronic device, comprising the printed circuit board of claim 9.
